Europäisches Patentamt

European Patent Office

Office européen des brevets

(11) Veröffentlichungsnummer: **0 308 939 B1**

(19)

# EUROPÄISCHE PATENTSCHRIFT

(12)

(45) Veröffentlichungstag der Patentschrift: **22.07.92**

(51) Int. Cl.⁵: **H01L 21/28**

(21) Anmeldenummer: **88115612.9**

(22) Anmeldetag: **22.09.88**

(54) Verfahren zur Herstellung eines MESFET mit selbstjustiertem Gate.

(30) Priorität: **23.09.87 DE 3732048**

(43) Veröffentlichungstag der Anmeldung:
**29.03.89 Patentblatt  89/13**

(45) Bekanntmachung des Hinweises auf die
Patenterteilung:
**22.07.92 Patentblatt  92/30**

(84) Benannte Vertragsstaaten:
**DE FR GB NL**

(56) Entgegenhaltungen:
**EP-A- 0 237 826**
**WO-A-85/04761**

**PATENT ABSTRACTS OF JAPAN, Band 10,
Nr. 117 (E-400) (2174), 2. Mai 1986; & JP-
A-60251671.**

**JOURNAL OF THE ELECTROCHEMICAL SO-
CIETY,Band 133, Nr. 10, Oktober 1986, Seiten
409-416c, New York, US; C.E. WEITZEL et al.:
" A Review af a GaAs MESFET Gate Electrode Fabrication Technologies"**

**IBM TECHNICAL DISCLOSURE BULLE-
TIN,Band 28, Nr. 3, August 1985, Seiten
916-917, New York, US:" Self-Aligned Reces-**

**sed Gate MESFET"**

(73) Patentinhaber: **SIEMENS AKTIENGESELL-
SCHAFT**
**Wittelsbacherplatz 2**
**W-8000 München 2(DE)**

(72) Erfinder: **Willer, Josef, Dr.**
**Hirschplanallee 3**
**W-8042 Oberschleissheim(DE)**

EP 0 308 939 B1

## Beschreibung

Die vorliegende Erfindung betrifft ein Verfahren zur Herstellung eines MESFET mit selbstjustiertem Gate nach dem Oberbegriff des Anspruchs 1.

Für die Herstellung von MESFET-Bauelementen, insbesondere im Rahmen der GaAs-Technik, sind in zunehmendem Maß Prozesse entwickelt worden, bei denen das Gate selbstjustierend ausgebildet wird. Eine besondere Bedeutung gewinnen dabei Herstellungsverfahren, bei denen zusätzlich zum Gate-Bereich auch Source- und Drain-Bereich selbstjustierend ausgebildet werden. Eine vollständige Selbstjustierung, bei der auch die Metallkontakte für Source, Drain und Gate selbstjustierend aufgebracht werden, hat zum Ziel, den Source-Drain-Abstand gegenüber der herkömmlichen Technik zu reduzieren und die Gate-Länge bei gleichzeitigem Einsatz optischer Lithographie bis auf etwa 0,1 $\mu$m zu verringern. Der damit gleichzeitig verringerte Source-Gate-Abstand bzw. der Abstand zwischen $n^+$-dotiertem Bereich und Gate sowie die kürzere Gate-Länge führen zu kleineren Widerständen und Kapazitäten, was sich sehr vorteilhaft auf die Hochfrequenztauglichkeit auswirkt.

Eine Übersicht über die derzeit gebräuchlichen Herstellungsverfahren von MESFET-Gates gibt der Artikel von C.E. Weitzel und D.A. Doane: "A Review of GaAs MESFET Gate Electrode Fabrication Technologies" in Journal of the Electrochemical Society 133, 409C bis 416C (1986). Zum Stand der Technik sei insbesondere auf drei Veröffentlichungen hingewiesen.

In dem IBM Technical Disclosure Bulletin 28, 916 bis 917 (1985) ist die Herstellung eines MESFET, bei dem Source- und Drain-Bereiche und deren jeweilige Metallisierungen selbstjustierend hergestellt werden, beschrieben. Angewendet werden dabei übliche Techniken wie Molekularstrahlepitaxie oder CVD (chemical vapour deposition) und Ionenätzen. Dabei wird auf einem Substrat aus semiisolierendem GaAs eine Kanalschicht aus n-dotiertem GaAs epitaktisch aufgewachsen. Für die Ausbildung der Source- und Drainbereiche folgt danach eine sogenannte Kontaktschicht aus hoch n-leitend dotiertem GaAs. Danach wird die Metallschicht, die die Elektroden für die Kontaktierung bildet, aufgebracht und von oben mit einer Isolatorschicht aus z.B. $SiO_2$ abgedeckt. Durch die Kontakt-, die Metall- und die Isolatorschicht wird ein Graben ausgeätzt, dessen Flanken in einem weiteren Prozeßschritt mit Distanzbereichen (Spacer) versehen werden. Zwischen diese Spacer, die in der Druckschrift als "Sidewalls" bezeichnet werden, wird das Metall der Gate-Metallisierung aufgebracht. Als alternative Ausführung schlagen die Autoren vor, auf das Aufbringen der Kanalschicht zu verzichten und stattdessen vor dem Anbringen der Spacer durch Ionenimplantation die für den Kanalbereich erforderliche Dotierung in das Substrat einzubringen. Dieser Herstellungsprozeß ist mit dem erheblichen Nachteil verbunden, daß für die Ausbildung der hoch n-leitend dotierten Source- und Drain-Bereiche ein zusätzlicher Epitaxieschritt erforderlich ist. Das Aufbringen der Kanalschicht erfordert einen weiteren Epitaxieschritt, oder der Kanalbereich muß durch nachträgliche Ionenimplantation hergestellt werden, was wegen des dann erforderlichen Ausheilprozesses hochtemperaturstabile Metallisierungen erfordert. Es ist aus der Druckschrift keine Angabe zu entnehmen, ob diese nachträgliche Ausbildung des Kanalbereiches einen brauchbaren Übergang zwischen diesem Kanalbereich und den hochdotierten Source- und Drain-Bereichen liefert. Eine irgendwie geartete Strukturierung des Kanalbereiches ist nicht vorgesehen.

In der Patentschrift US-A 44 72 872 ist ein Verfahren beschrieben, bei dem auf einem GaAs-Substrat durch Dotierung eine aktive Schicht und darauf mit Abhebetechnik eine durch einen Graben unterbrochene Schichtfolge aus Gold-Germanium-Legierung als Metallschicht für die ohmsche Kontaktierung und Aluminium aufgebracht werden, sodann auf den Seiten des Grabens Spacer ausgebildet werden und nach Entfernen der Aluminiumschicht eine Platinschicht zur äußeren Kontaktierung aufgebracht wird, wobei durch die Spacer gleichzeitig die Unterbrechung zwischen Source-, Gate- und Drain-Kontakt bewirkt werden soll. In einem letzten Schritt werden die Spacer und mit ihnen ein Teil des Gate-Metalles entfernt. Bei diesem Verfahren ist keine $n^+$-Dotierung der Source- und Drain-Bereiche möglich.

In der europäischen Patentanmeldung EP-A-0 237 826, die zum Stand der Technik gemäß Artikel 54 (3) EPÜ gehört, ist ein Verfahren beschrieben, bei dem eine Kontaktschicht aus Metall und eine Dielektrikumschicht auf ein Substrat aufgebracht werden, wobei eine grabenförmige Aussparung mit einem Maskierungselement mit hinterschnittener Form erzielt wird. Anschließend werden durch anisotropes Ätzen einer ganzflächig isotrop aufgebrachten weiteren Dielektrikumschicht Spacer ausgebildet, zwischen denen das Gate-Metall aufgebracht wird. In Abhängigkeit von dem angewendeten Dotierungsprozeß kann vor dem Abscheiden des Gate-Metalles eine Vertiefung in die Substratoberfläche geätzt werden, um den Kanalbereich zu verengen.

Bei der Dummy-Gate-Technik wird zunächst ein Hilfsgate (dummy gate) abgeschieden, das als Implantationsmaske dient und nach weiteren Prozeßschritten durch ein Gate-Metall ersetzt wird. Diese Technik ist selbstjustierend bezüglich Source-, Drain-und Gate-Bereich, aber nicht bezüglich der entsprechenden Kontaktmetalle.

Bei der Spacer-Technik von NEC entfallen die n[+]-Bereiche, weil das Metall für die ohmschen Kontakte self-aligned an die Gate-Kanten rückt. Ein einfaches T-Gate mit großem Querschnitt ist nicht möglich, was sich bei Strukturverfeinerung nachteilig auswirkt.

Das auf einen Vorschlag von Fujitsu (M. Yokoyama e.a. in IEEE ISSCC 1981, 281 bis 219) zurückgehende SAGFET-Verfahren wird inzwischen in verschiedenen Varianten untersucht. Sie alle benötigen einen Schottky-Kontakt, der die Ausheilprozedur nach der Implantation übersteht, was ein großes Problem darstellt.

Dieses Verfahren ist selbstjustierend bezüglich der n[+]-Implantation und des Gate-Bereiches.

Beim SAINT-Prozeß wird die n[+]-Implantation durch eine Fotolackstruktur mit $SiO_2$-Deckschicht begrenzt. Nach verschiedenen Prozeßschritten wird die Lackstruktur durch das Gatemetall ersetzt, das bezüglich der Source- und Drain-Bereiche, nicht aber bezüglich der Source- und Drain-Metallkontakte selbstjustiert ist. Eine Strukturverkleinerung erfordert hierbei nichtlichtoptische Lithographie.

Aufgabe der vorliegenden Erfindung ist es, ein Verfahren zur Herstellung eines MESFET anzugeben, bei dem das Gate bezüglich der Source- und Drain-Bereiche sowie der Source- und Drain-Metallisierungen selbstjustierend in möglichst einfacher, möglichst wenige Prozeßschritte umfassender Weise hergestellt wird und der Kanalbereich so strukturiert werden kann, daß niedrige Einsatz- und hohe Durchbruchspannung erzielt werden.

Diese Aufgabe wird bei dem erfindungsgemäßen Verfahren durch die Merkmale des Anspruches 1 gelöst.

Der hier vorgeschlagene Prozeß gestaltet sich wie folgt. Eine Schicht an der Oberfläche des Substrates wird durch selektive Implantation dotiert und etwaige Gitterschäden ausgeheilt. Die Oberfläche dieser Dotierungsschicht wird ganzflächig mit einer ersten Metallschicht versehen, die mit dem Halbleitermaterial des Substrates einen ohmschen Kontakt bildet. Auf diese erste Metallschicht wird ganzflächig eine erste Dielektrikumschicht, z.B. aus Siliziumdioxid, aufgebracht.

Die Oberfläche dieser Dielektrikumschicht wird mit einer Fotolackmaske versehen. Durch einen anisotropen Ätzprozeß (z.B. Ionenbeschuß oder RIE) wird in dem von der Lackmaskenschicht freigelassenen für den Gate-Bereich vorgesehenen Teil des Bauelementes durch die Dielektrikum- und Metallschicht bis in die Dotierungsschicht des Substrates hinein ein Graben ausgeätzt.

Dieser anisotrope Ätzprozeß wird so weit in die Dotierungsschicht des Substrates fortgesetzt, daß in Verbindung mit den nachfolgenden Prozeßschritten und unter Berücksichtigung des Dotierungsprofils dieser Dotierungsschicht das fertige Gate diejenige geometrische Struktur erhält, die die erwünschten physikalischen Eigenschaften, insbesondere niedrige Einsatzspannung und hohe Durchbruchspannung, gewährleistet.

Die Lackmaskenschicht wird entfernt und die strukturierte Oberfläche unter Anwendung eines Verfahrens für isotrope Abscheidung, z.B. CVD (chemical vapour deposition), mit einer zweiten Dielektrikumschicht, z.B. aus Siliziumdioxid, bedeckt. Diese zweite Dielektrikumschicht wird anschließend anisotrop mittels Ionenätzen oder RIE rückgeätzt, so daß an den Flanken des in den vorhergehenden Prozeßschritten ausgeätzten Grabens Distanzbereiche, sogenannte Spacer, stehenbleiben. Für den Ätzprozeß kann z.B. Schwefelhexafluorid ($SF_6$), gegebenenfalls mit $O_2$, oder Tetrafluorkohlenstoff ($CF_4$), auch hier gegebenenfalls mit $O_2$, eingesetzt werden.

Im Bereich zwischen den Spacern kann die Dotierungsschicht des Substrates durch Ätzen weiter in ihrer Dicke reduziert werden, was durch Anwendung chlorhaltiger Gase oder mittels Ionenbeschuß geschehen kann. Mit diesem Vorgehen wird eine zweifache Verengung des Kanalbereiches (double recess) hergestellt und damit die Einsatzspannung des Transistors eingestellt. In einem anschließenden Temperschritt können die bei den vorhergehenden Prozeßschritten entstandenen Gitterschäden im Halbleitermaterial, insbesondere im Bereich zwischen Source und Drain, ausgeheilt werden. Abschließend wird das Gate-Metall aufgebracht, das z.B. aus der Schichtfolge Titan-Platin-Gold bestehen kann. Die Strukturierung der Gate-Metallisierung geschieht entweder durch Ätzen nach ganzflächiger Abscheidung oder in Abhebetechnik nach gerichteter Abscheidung.

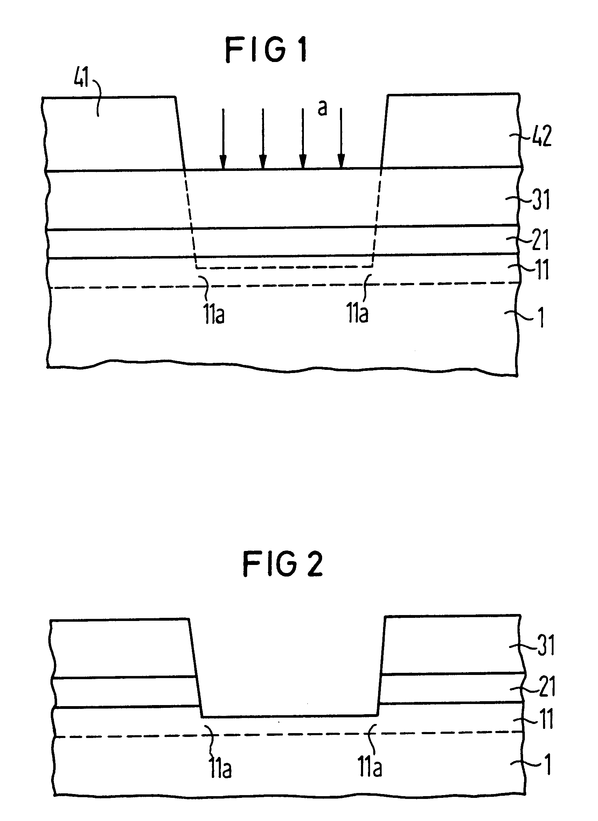

Es folgt die Beschreibung eines exemplarischen Prozeßablaufes anhand der Figuren 1 bis 6, die das Bauelement mit Gate-Bereich, Source-Bereich und Drain-Bereich im Querschnitt zeigen.

Figur 1 zeigt den Gate-Bereich mit Substrat 1 mit ausgebildeter Dotierungsschicht 11 nach dem Aufbringen der ersten Metallschicht 21, der ersten Dielektrikumschicht 31 und der ersten Lackmaskenschicht 41, 42. Mit vertikalen Pfeilen ist der Prozeßschritt des anisotropen Ätzens a angedeutet. Dieser Ätzschritt wird so weit vorgenommen, bis der durch die gestrichelte Kontur dargestellte Graben in der ersten Dielektrikumschicht 31, der ersten Metallschicht 21 und dem oberen Bereich der Dotierungsschicht 11 ausgeätzt ist.

Figur 2 zeigt den Gate-Bereich nach erfolgtem anisotropen Ätzen a und anschließendem Entfernen der ersten Lackmaskenschicht 41, 42. Unterhalb des ausgeätzten Grabens befindet sich der streifenförmige Bereich, in dem die Dicke der Dotierungsschicht 11 vermindert ist. Die tiefgelegenen Teile der Flanken des ausgeätzten Grabens bilden einen Rücksprung oder Vertiefung 11a in der Oberfläche der Dotierungsschicht 11 des Substrates 1.

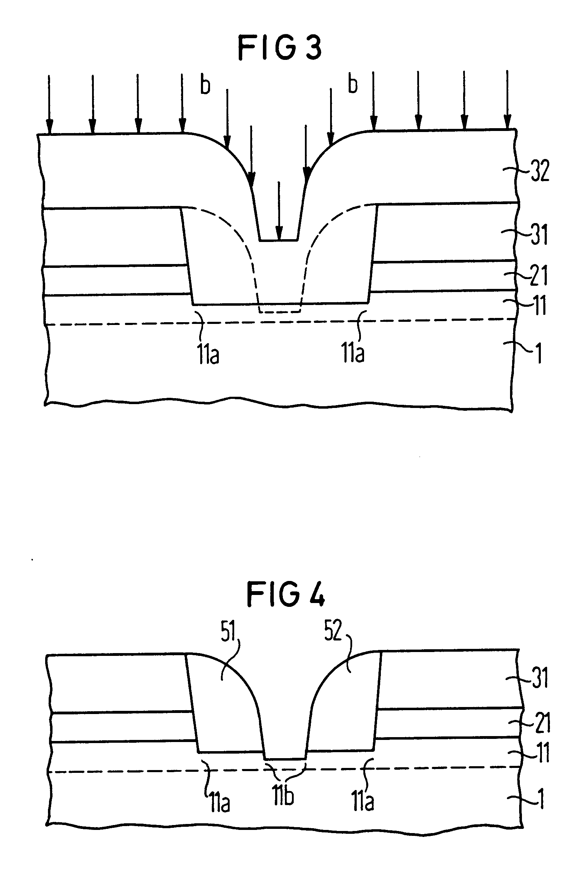

Figur 3 zeigt den Gate-Bereich nach isotropem Abscheiden der zweiten Dielektrikumschicht 32. Durch vertikale Pfeile ist der nachfolgende Schritt des anisotropen Ätzens b angedeutet. Bei diesem Ätzschritt wird die zweite Dielektrikumschicht 32 überall in vertikaler Richtung, d.h. der Pfeilrichtung, in gleicher Stärke rückgeätzt. Dabei wird der auf der ersten Dielektrikumschicht 31 befindliche Anteil der zweiten Dielektrikumschicht 32 vollständig weggeätzt. Infolge der Anisotropie dieses Ätzschrittes bleiben in dem in den vorhergehenden Prozeßschritten ausgeätzen Graben an den Flanken zwei Distanzbereiche, ein erster Spacer 51 und ein zweiter Spacer 52 stehen.

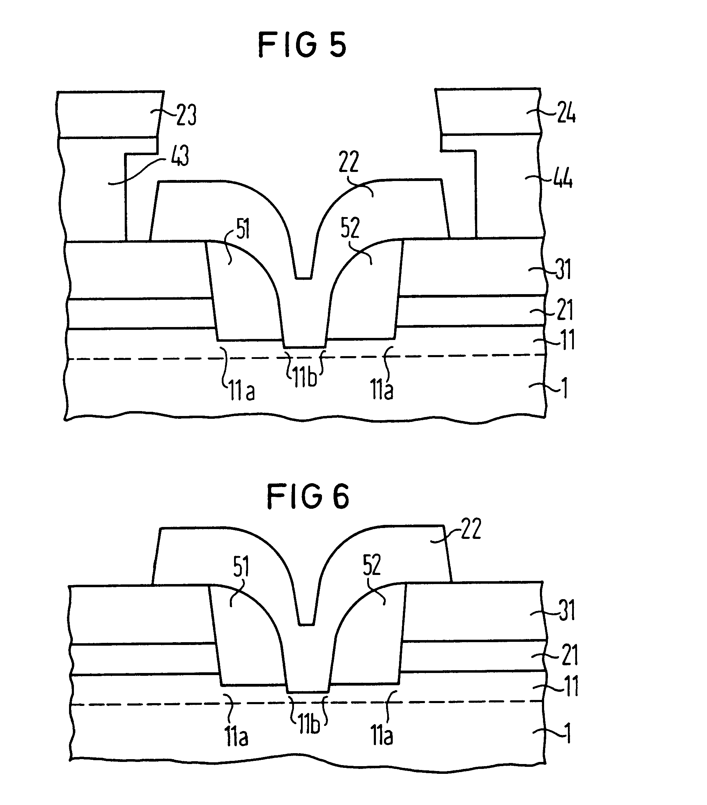

Figur 4 zeigt den Aufbau des Gate-Bereiches nach dem eben beschriebenen Ätzschritt, der zwischen den Spacern 51, 52 in die Dotierungsschicht 11 des Substrates 1 hinein fortgesetzt werden kann, so daß sich in dieser Dotierungsschicht 11 ein innerer Bereich erneut verminderter Dicke dieser Dotierungsschicht 11 ergibt. Damit erhält die Dotierungsschicht 11 des Substrates 1 einen weiteren, inneren Rücksprung 11b. Die Oberfläche der Dotierungsschicht 11 des Substrates 1 besitzt in diesem Fall einen äußeren Rücksprung 11a von etwa 1,2 $\mu$m Länge und einen inneren Rücksprung 11b von etwa 0,3 $\mu$m Länge. Durch Ausätzen des inneren Bereiches zusätzlich verminderter Dicke der Dotierungsschicht 11 läßt sich die Eingangsspannung des Transistors auf den vorgegebenen Wert einstellen. Der sich aus der Kombination von äußerem Rücksprung 11a und innerem Rücksprung 11b ergebende doppelte Rücksprung (double recess) erlaubt es, die Einsatzspannung niedrig und gleichzeitig die Durchbruchspannung zwischen Gate und Source bzw. Drain hoch zu halten.

Figur 5 zeigt den Aufbau des Gate-Bereiches nach dem Aufbringen einer zweiten Lackmaskenschicht 43, 44 und anschließendem anisotropem Anscheiden der Gate-Metallisierung, wobei eine zweite Metallschicht 22, 23, 24 aufgebracht wird. Diese zweite Metallschicht besteht aus einem ersten Anteil 22, der die Gate-Metallisierung bildet, und einem zweiten Anteil 23, 24 auf der zweiten Lackmaskenschicht 43, 44. Dieser zweite Anteil 23, 24 der zweiten Metallschicht wird zusammen mit der zweiten Lackmaskenschicht 43, 44 abgehoben.

Figur 6 zeigt das fertige Gate nach diesem letzten Prozeßschritt. Es besteht aus dem Substrat 1 mit der Dotierungsschicht 11, in dessen Oberfläche ein äußerer Rücksprung 11a und ein innerer Rücksprung 11b ausgebildet sind, darauf die Metallschicht 21 und die Dielektrikumschicht 31 mit der die beiden Spacer 51, 52 enthaltenden grabenförmigen Aussparung und dem Gatemetall 22.

Da bei dem vorgeschlagenen Prozeß die Metallschicht für den ohmschen Kontakt nicht gleichzeitig mit dem Ausheilprozeß der implantierten Dotierung einlegiert werden muß, kommt für diesen ohmschen Kontakt sowohl ein konventioneller als auch ein hochtemperaturfester in Betracht. Der erfindungsgemäße Prozeß ist selbstjustierend und passiviert zugleich die GaAs-Oberfläche im aktiven Bereich. Obwohl mit optischer Lithographie sonst die feinsten herstellbaren Strukturen bei 0,7 $\mu$m liegen, können mit dem hier beschriebenen Prozeß MESFET mit 0,1 $\mu$m Gate-Länge hergestellt werden. Der Gate-Metall-Querschnitt wird trotz der kleinen Gate-Länge groß gehalten, so daß große Gate-Weiten realisiert werden können. Die gesamten Strukturierungsschritte sind in Trockenätztechnik ausführbar, d.h. alle Metalle können hochtemperaturstabil (refractory metals) sein.

**Patentansprüche**

1. Verfahren zur Herstellung eines MESFET mit selbstjustiertem Gate mit einem Substrat (1) aus Halbleitermaterial, einer ersten Metallschicht (21), einer zweiten Metallschicht (22) als Gate-Metall, einer ersten Dielektrikumschicht (31), Spacern (51,52), wobei Implantationstechnik, Ausheilverfahren, Maskentechnik, anisotrope Ätztechnik und Abscheidetechnik angewendet werden,
   **dadurch gekennzeichnet,**
   - daß mit selektiver Implantation und anschließender Ausheilung an der Oberfläche des Substrates (1) eine Dotierungsschicht (11) ausgebildet wird, die die Source-, Drain- und Gate-Bereiche des MESFET formt,
   - daß auf dieser Dotierungsschicht (11) ganzflächig die erste Metallschicht (21) aus einem für ohmschen Kontakt verwendbaren Metall aufgebracht wird,
   - daß auf dieser ersten Metallschicht (21) ganzflächig die erste Dielektrikumschicht (31) aufgebracht wird,
   - daß auf diese erste Dielektrikumschicht (31) eine erste Lackmaskenschicht (41,42) aufgebracht wird,
   - daß mit anisotropem Ätzen (a) in den von der ersten Lackmaskenschicht (41,42) freigelassenen Bereich durch die erste Dielektrikumschicht (31) und die erste Metallschicht (21) bis in die Dotierungsschicht (11) des Subtrates (1) ein Graben ausgeätzt wird, so daß sich in dieser Dotierungsschicht (11) eine Vertiefung (11a) in der Substratoberfläche ergibt, und so daß die Teile der ersten Metallschicht (21), die über der Dotierungsschicht (11) zurückbleiben, die Source- und Drain-Kontakte bilden,

- daß dieser Graben so tief in die Dotierungsschicht (11) des Substrates (1) hinein geätzt wird, daß unter Berücksichti-gung des Dotierungsprofils der Dotie-rungsschicht (11) die vorgegebene Min-destdurchbruchspannung für das herzu-stellende Gate sichergestellt ist,

- daß mit isotropem Abscheiden auf der wie angegeben strukturierten Oberfläche eine zweite Dielektrikumschicht (32) aufgebracht wird,

- daß mit anisotropem Ätzen (b) diese zweite Dielektrikumschicht (32) mit Ausnahme von Spacern (51,52), die an den Seiten-Wänden des Grabens zurückbleiben, weggeätzt wird und

- daß die zweite Metallschicht (22) als Gate-Metall aufgebracht wird.

2. Verfahren nach Anspruch 1,
**dadurch gekennzeichnet,**
daß die zweite Metallschicht (22) zunächst ganzflächig aufgebracht und anschließend durch Ätzen strukturiert wird.

3. Verfahren nach Anspruch 1,
**dadurch gekennzeichnet,**
daß das Gate-Metall mit Abhebetechnik in der Weise aufgebracht wird,

- daß zunächst eine zweite Lackmaskenschicht (43,44) aufgebracht wird,

- daß durch gerichtetes Abscheiden eine zweite Metallschicht (22,23,24) aufgebracht wird, wobei ein erster Anteil (22) dieser zweiten Metallschicht (22,23,24) die Gate-Metallisierung bildet und ein zweiter Anteil (23,24) dieser zweiten Metallschicht (22,23,24) sich auf der zweiten Lackmaskenschicht (43,44) befindet und

- daß der zweite Anteil (23,24) der zweiten Metallschicht (22, 23,24) zusammen mit der zweiten Lackmaskenschicht (43,44) abgehoben wird.

4. Verfahren nach einem der Ansprüche 1 bis 3,
**dadurch gekennzeichnet,**
daß das Substrat (1) III-V-Halbleitermaterial ist.

5. Verfahren nach einem der Ansprüche 1 bis 4,
**dadurch gekennzeichnet,**
daß als Dielektrikum Siliziumoxid abgeschieden wird.

6. Verfahren nach einem der Ansprüche 1 bis 5,
**dadurch gekennzeichnet,**

daß das Substrat (1) GaAs ist.

7. Verfahren nach einem der Ansprüche 1 bis 6,
**dadurch gekennzeichnet,**
daß vor Abscheiden des Gate-Metalles in ei-nem zusätzlichen Temperschritt die Ausheil-ung möglicher entstandener Gitterschäden im Halbleitermaterial bewirkt wird.

8. Verfahren nach einem der Ansprüche 1 bis 7,
**dadurch gekennzeichnet,**
daß im Anschluß an das anisotrope Ätzen (b) der zweiten Dielektrikumschicht (32) die Dotierungsschicht (11) des Substrates (1) zwischen dem ersten (51) und zweiten Spacer (52) zur Einstellung der Einsatzspannung des Transistors tiefer ausgeätzt wird, so daß sich in der Dotierungsschicht (11) eine innere Vertiefung (11b) in der Substratoberfläche ergibt.

**Claims**

1. Method of manufacturing a MESFET having a self-aligned gate, comprising a substrate (1) of semiconductor material, a first metal layer (21), a second metal layer (22) as gate metal, a first dielectric layer (31), spacers (51, 52), in which method implantation technology, annealing methods, masking technology, anisotropic etching technology and deposition technology are used, characterised

- in that a doping layer (11), which forms the source, drain and gate regions of the MESFET, is formed at the surface of the substrate (1) by selective implantation and subsequent annealing,

- in that the first metal layer (21) composed of a metal which can be used for ohmic contact is deposited over the entire area of said doping layer (11),

- in that the first dielectric layer (31) is deposited over the entire area of said first metal layer (21),

- in that a first resist mask layer (41, 42) is deposited on said first dielectric layer (31),

- in that a trench is etched out by anisotropic etching (a) through the first dielectric layer (31) and the first metal layer (21) down into the doping layer (11) of the substrate (1) in the region left free by the first resist mask layer (41, 42) so that a recess (11a) is produced in the substrate surface in said doping layer (11) and so that the parts of the first metal layer (21) which remain behind on top of the doping layer (11) form the source and drain contacts,

- in that said trench is etched into the doping layer (11) of the substrate (1) to such a depth that, allowing for the doping profile of the doping layer (11), the specified minimum breakdown voltage for the gate to be manufactured is ensured,
- in that a second dielectric layer (32) is deposited by isotropic deposition on the surface which has been structured as specified,
- in that said second dielectric layer (32) is etched away by anisotropic etching (b) with the exception of spacers (51, 52) which remain behind at the side walls of the trench, and
- in that the second metal layer (22) is deposited as gate metal.

2. Method according to Claim 1, characterised in that the second metal layer (22) is first applied over the entire area and then structured by etching.

3. Method according to Claim 1, characterised in that the gate metal is deposited by lift-off technology in such a way
   - that a second resist mask layer (43, 44) is first deposited,
   - that a second metal layer (22, 23, 24) is deposited by directed deposition, a first component (22) of said second metal layer (22, 23, 24) forming the gate metallisation and a second component (23, 24) of said second metal layer (22, 23, 24) being located on the second resist mask layer (43, 44), and
   - that the second component (23, 24) of the second metal layer (22, 23, 24) is lifted off together with the second resist mask layer (43, 44).

4. Method according to one of Claims 1 to 3, characterised in that the substrate (1) is III-V semiconductor material.

5. Method according to one of Claims 1 to 4, characterised in that silicon oxide is deposited as dielectric.

6. Method according to one of Claims 1 to 5, characterised in that the substrate (1) is GaAs.

7. Method according to one of Claims 1 to 6, characterised in that, before the gate metal is deposited, any lattice defects produced in the semiconductor material are annealed out in an additional heat-treatment step.

8. Method according to one of Claims 1 to 7, characterised in that, following the anisotropic etching (b) of the second dielectric layer (32), the doping layer (11) of the substrate (1) is etched out more deeply between the first (51) and second spacer (52) to set the threshold voltage of the transistor, so that an inner recess (11b) is produced in the substrate surface in the doping layer (11).

**Revendications**

1. Procédé pour fabriquer un transistor MESFET à grille autoalignée, comportant un substrat (1) formé d'un matériau semiconducteur, une première couche métallique (21), une seconde couche métallique (22) formant métal de grille, une première couche diélectrique (31), des entretoises (51,52), et selon lequel on utilise une technique d'implantation, un procédé de recuit, une technique de masquage, une technique de corrosion anisotrope et une technique de dépôt,
   caractérisé par le fait
   - qu'au moyen d'une implantation sélective et d'un recuit ultérieur, on forme, au niveau de la surface du substrat (1), une couche de dopage (11), qui forme les régions de source, de drain et de grille du transistor MESFET,
   - que sur l'ensemble de cette couche de dopage (11), on dépose la première couche métallique (21) formée d'un métal utilisable pour un contact ohmique,
   - que sur l'ensemble de cette première couche métallique (21), on dépose la première couche diélectrique (31),
   - que sur cette première couche diélectrique (31), on dépose une première couche de masquage formée d'une laque (41,42),
   - qu'on forme un sillon au moyen d'une corrosion anisotrope exécutée dans la région, laissée libre par la première couche de masquage formée de laque (41,42) et à travers la première couche diélectrique (31) et la première couche métallique (21) et jusqu'à la couche de dopage (11) du substrat (1), de sorte qu'il apparaît, dans cette couche de dopage (11), un renfoncement (11a) situé dans la surface du substrat, et que les parties de la première couche métallique (21), qui subsistent au-dessus de la couche de dopage (11), forment les contacts de source et de drain;
   - qu'on ménage par corrosion ce sillon suffisamment profondément dans la couche de dopage (11) du substrat (1) pour que, compte tenu du profil de dopage de la couche de dopage (11), la tension de claquage minimale prédéterminée pour la grille devant être fabriquée soit garantie,

- qu'au moyen d'un dépôt isotrope sur la première couche structurée comme indiqué, on dépose une seconde couche diélectrique (32),
- qu'au moyen d'une corrosion anisotrope (b), on élimine par corrosion cette seconde couche diélectrique (32) à l'exception d'entretoises (51,52), qui subsistent sur les parois latérales du sillon, et
- qu'on dépose la seconde couche métallique (22) sous la forme d'un métal de grille.

2. Procédé suivant la revendication 1, caractérisé par le fait qu'on dépose tout d'abord la seconde couche métallique (22) sur toute la surface et qu'on la structure ensuite par corrosion.

3. Procédé suivant la revendication 1, caractérisé par le fait qu'on dépose le métal de grille au moyen d'une technique de décollage de la manière suivante

- qu'on dépose tout d'abord une seconde couche de masquage formée d'une laque (43,44),
- qu'on dépose, au moyen d'un dépôt orienté, une seconde couche métallique (22,23,24), auquel cas une première partie (22) de cette seconde couche métallique (22,23,24) forme la métallisation de grille et une seconde partie (23,24) de cette seconde couche métallique (22,23,24) est située sur la seconde couche de masquage formée d'une laque (43,44), et
- qu'on élimine la seconde partie (23,24) de la seconde couche métallique (22,23,24) conjointement avec la seconde couche de masquage formée d'une laque (43,44).

4. Procédé suivant l'une des revendications 1 à 3, caractérisé par le fait que le substrat (1) est un matériau semiconducteur (III-V).

5. Procédé suivant l'une des revendications 1 à 4, caractérisé par le fait qu'on dépose, en tant que diélectrique, de l'oxyde de silicium.

6. Procédé suivant l'une des revendications 1 à 5, caractérisé par le fait que le substrat (1) est formé de GaAs.

7. Procédé suivant l'une des revendications 1 à 6, caractérisé par le fait qu'avant le dépôt du métal de grille, on réalise, lors d'une étape supplémentaire de recuit, le recuit de défauts de la grille, éventuellement apparus, dans le matériau semiconducteur.

8. Procédé suivant l'une des revendications 1 à 7, caractérisé par le fait qu'à la suite de la corrosion anisotrope (b) de la seconde couche diélectrique (32), on élimine plus profondément, par corrosion, la couche de dopage (11) du substrat (1) entre la première entretoise (51) et la seconde entretoise (52) pour régler la tension de déclenchement du transistor de sorte qu'on obtient, dans la couche de dopage (11), un renfoncement intérieur (11b) dans la surface du substrat.

# FIG 1

# FIG 2

# FIG 3

# FIG 4

# FIG 5

# FIG 6